# EUROPÄISCHE PATENTSCHRIFT

(11) **EP 0 355 476 B1**
(45) Veröffentlichungstag und Bekanntmachung des Hinweises auf die Patenterteilung: **22.09.1999**
(21) Anmeldenummer: 89114003.0
(22) Anmeldetag: 28.07.1989
(51) Int. Cl.: C30B 15/00, C30B 29/30

(54) **Zusammensetzung für die Züchtung von homogenen Lithium-Niobat-Kristallen**
Composition for growth of homogeneous lithium niobate crystals
Composition pour la croissance de cristaux homogènes des niobate de lithium

(30) Priorität: 26.08.1988 US 236960
(43) Veröffentlichungstag der Anmeldung: 28.02.1990
(73) Patentinhaber: SIEMENS AKTIENGESELLSCHAFT, 80333 München (DE)
(72) Erfinder: Bordui, Peter F., Menlo Park, CA 94025 (US); Norwood, Richard G., San Jose, CA 95121 (US); Nightingale, John L., Woodside, CA 94062 (US)

(56) Entgegenhaltungen:
- CHEMICAL ABSTRACTS, vol. 107, no. 8, 24 August 1987, page 647, abstract no. 68686m, Columbus, Ohio, US; & JP-A-62 78 197 (AMERICAN TELEPHONE AND TELEGRAPH CO.) 10-04-1987
- PATENT ABSTRACTS OF JAPAN, vol. 10, no. 214 (C-362)[2270], 25 July 1986; & JP-A-61 53 200 (HAMAMATSU PHOTONICS K.K.) 17-03-1986
- REVIEW OF THE ELECTRICAL COMMUNICATION LABORATORIES, vol. 23, no. 5-6, May-June 1975, pages 569-580; K. SUGII et al.: "Characterization of LiNbO3 single crystals by X-ray topography"

## Beschreibung

This invention relates to the manufacture of crystalline materials primarily for acoustic and optical applications, and it relates, more particularly, to the formation of homogeneous crystals in an improved process wherein substantially all of the liquid material is efficiently converted into crystalline material of spatially uniform properties throughout its volume.

The useful properties of single crystalline lithium niobate, such as associated with its energy transmissive crystal structure and piezoelectric nature, have long been recognized and are responsible for extensive and widespread applications for sometime. Although often noted as "LiNbO₃", the lithium niobate phase encompasses a relatively broad range of composition, with possible Li to Nb elemental ratios from roughly 44 to 50 mol% Li. Due to the rather adaptive nature of the dynamic, complex, crystal growing process for forming such crystalline material, efficiency of production and uniformity of product have until now continued to elude crystal growers.

Lithium niobate is typically prepared in single crystal form by pulling crystals in the well-known Czochralski process. Single crystal boules as large as 10 kg have been prepared in this way.

Central to any solidification process, including the Czochralski process, is the concept of "congruency". A liquid is considered to solidify "congruently" if, on cooling, it produces a solid of exactly the same composition as the liquid. by contrast, in incongruent solidification, the solid forming at any time has a composition different from that of the immediately adjacent freezing liquid. The consequence is rejection of some chemical component from the solidification front back into the liquid. As solidification progresses, this rejection effects a gradual enrichment of the liquid by the rejected species which in turn results in spatial variation of the chemical composition of the resulting solidified body. As a result, the failure to begin with the exact "congruent" composition drives the liquid phase composition even further away from the correct composition which makes it impossible to produce crystals of spatial uniformity in a high yielding process.

In a practical production process for single crystalline material of a given phase, congruent solidification, if possible, is generally preferred to incongruent solidification largely for two reasons. First, from a crystal production standpoint, a congruent solidification process is generally more efficient. Due to the rejection phenomena going on at an incongruent solidification front, conventional growth rates must be kept relatively low to avoid interfacial breakdown effects that would otherwise result in a highly defective product. Also, due to the build-up of rejected species in the liquid as incongruent solidification progresses, the fraction of a given.volume of liquid that can be successfully crystallized is limited. In addition, the spatial variation in composition in a crystal grown incongruently may also result in spatial variation of its thermal expansion properties. As a consequence, there is a tendency to crack on subsequent cooling.

Second, from the standpoint of using fabricated crystalline material in construction of electronic, optical, or acoustic devices, a congruent solidification process yields more desirable material. Efficient production of high-performance crystal-based devices to tight design tolerances requires high uniformity in critical crystal material properties, both within individual pieces and from piece to piece. Generally, such uniformity in critical material properties in turn requires uniformity in crystal composition. Clearly, a congruent solidification process favors such uniformity in crystal composition.

The subject of congruency as it relates to lithium niobate Czochralski growth has been a rather confused issue from the earliest work on the material. In large part, difficulty in resolving the confusion has been due to the practical difficulty in measuring to necessary precision the chemical composition of crystalline lithium niobate. Due to the extremely low solubility of solid lithium niobate in common acids, standard wet-chemical analytical techniques like Curie temperature measurement and non-linear optical phase-match temperature measurement are rather subtle in their application.

Initial lithium niobate growth work was based on the belief that the congruent composition should be a Li:Nb ratio of 50 mol% Li. In 1968, Lerner et al. in the Journal of Crystal Growth ¾ (1968) 231 reported the congruent composition to lie between 48 and 49 mol% Li. Later, Carruthers et al. in the Journal of Applied Physics 42 (1971) 1846 reported the congruent composition as 48.60 mol% Li. In 1974, Chow et al., Mat Research Bull. 9 (1974) 1067 determined that the congruent composition lies between 48.50 and 48.60 mol% Li. In 1985, O'Bryan et al. in the Journal of the American Ceramic Society 68 (1985) 493 reported the congruent composition as 48.45 mol% Li. O'Bryan et al. disclose the same congruent composition of 48,45 mol%Li in JP-62 78 197. Most recently, in Applied Physics Letters 53 (1988) 260 Wen et al. made an uncited reference to a congruent composition value of 48.71 mol% Li. Non prepublished EP-A1-0 417 132 (PCT/DE 89/00341) reports that for a lithium niobate single crystal having the crystal orientation rot-y at 127,86° relative to the Z-direction the composition is 48,25 ± 0,1 mol% Li.

Obviosly, not all of the foregoing conflicting reports on congruent compositions can be correct. Moreover, each of these studies is open to serios doubt, due to one or more of several shortcomings. Primarily, these drawbacks are:
(1) Inaccuracy or imprecision in compositional measurement technique,
(2) Growth of crystals representing total melt fractions smaller than desirable for maximizing effects of incongruency,
(3) Compositional characterization of specimens inappropriately large with respect to the size of the parent crystals being analyzed, and
(4) Analysis of measurement results based on dubious extension of approximate theoretical construction.

If one were to take as an illustration the recent work by O'Bryan et al., these people skilled in the art based an analysis of a preferred lithium niobate growth composition on compositional measurements they performed on both fabricated crystalline specimens cut from lithium niobate crystals and solidified polycrystalline samples withdrawn from the corresponding melts used in crystal growth. The compositional measurements were performed using a differential thermal analysis (DTA) technique to determine the ferroelectric Curie temperature of each of the samples. It is also significant to note that the fraction of liquid crystallized only corresponded to 0.72 of the melt.

The precision on the Curie temperature measurements of O'Bryan et al. was quoted as ± 2°C. Such precision in Curie temperature measurement corresponds to a roughly ± 0.2 mol% Li precision in specifying melt composition for growth. It is generally known and is confirmed in data and discussion presented hereinafter that such wide error bars associated with specifying melt composition are unable to provide a significant improvement in lithium niobate crystal production beyond present conventional commercial practices of those skilled in the art.

### SUMMARY OF THE INVENTION

It is one of the primary objects of the present invention in the solidification of lithium niobate to determine the true congruent relationship between melt composition and crystallized composition using measurement techniques and crystal growth techniques resulting in more accurate material characterization over that of conventional crystal growth processes.

Another primary object of the invention is the formation of homogeneous crystals each having spatially uniform properties throughout its volume wherein substantially all of the melt is included in the crystalline material.

Other related objects are efficient solidification of crystalline lithium niobate in terms of speed, reproducibility, and consistency.

A further object is to enable the production of crystal boules of larger diameters and more uniform properties than conventional techniques.

A further object is to determine a compositional relationship between lithium and niobium producing congruent crystal growth for any axial orientation selected for homogeneous crystal growth.

A feature utilized in crystal growth technique is the solidification of large portions, 0.85 or more, of the melt for enhancing the effects of incongruency for insuring detection of its presence in cases where it would otherwise be not as distinct.

The invention takes the form of positive results of a controlled scientific experiment involving modification of the starting composition in a process for producing monocrystalline lithium niobate of uniform and reproducible properties by virtue of being homogeneous. All parameters of the process and measurement techniques were refined to the point of being compatible to yield reproducible and accurate measurements of the resulting crystalline material. In the course of determining the congruent composition, investigation was employed to arrive at the limits of a compositional range which would produce homogeneous crystalline lithium niobate under normal processing situations. Crystalline homogeneity provides unprecendented constancy of the properties of lithium niobate so as to improve its application as a substrate material in all conventional uses while also enhancing the production characteristics of the material itself.

In accordance with the invention, a melt solution comprising a composition range from but not including 48.35 mol percent to 48.395 mol percent of Li₂O with the remainder being Nb₂O₅ produced compositionally uniform crystalline material superior to conventional lithium niobate. In addition, the production of crystallized material corresponded to at least 0.85 of the melt solution which exceeds the output heretofore obtainable.

In a process for freezing homogeneous lithium niobate out of a melt solution on a crystal seed, a melt solution was prepared having a compositional range in terms of mol percent of Li₂O of 48.375±0.010 to 48.385±0.010 with the remainder of the melt solution being Nb₂O₅. From this melt, production of crystalline material routinely corresponded to 0.95 of the melt solution.

The invention is based on the use of an accurately controlled lithium niobate liquid composition of 48.38 mol% Li to grow single crystals of solid lithium niobate better suited for optical and acoustic uses than conventionally grown crystals.

### BRIEF DESCRIPTION OF THE DRAWING

Additional features of the invention and additional objects of the invention will be more readily appreciated and better understood by reference to the following detailed description which should be considered in conjunction with the drawing.

Fig. 1 is a schematic illustration of a Czochralski type crystal growth station.

Fig. 2 provides an overall diagram of the measurement system for determining the ferroelectric Curie transition of lithium niobate produced by the inventive process.

Figs. 3 and 4 are tables listing measurement values.

Fig. 5 depicts a substrate of lithium niobate suitable for acoustic or optical applications.

### DETAILED DESCRIPTION

### Initial Compositional Preparation for Growth of Homogeneous Lithium Niobate Crystals

A small sample was withdrawn from a roughly 100 kg barrel of high-purity Li₂CO₃ powder. This powder in the barrel had been previously sampled and characterized using thermal ionization mass spectrometry to establish an average atomic weight for the contained lithium of 6.942. The small sample was placed in a 21.900 g Pt (platinum) dish. An electronic balance was used to determine the combined mass of the dish and sample to be 33.573 g. The Pt dish and sample were placed in a muffle furnace at 500° C in air for 10 minutes. On removal from the furnace, the dish and sample were allowed to cool in a dry-atmosphere glove box for 10 minutes. The dish and sample were re-measured on the balance and, in this case, found to have a mass of 33.506 g. A moisture loss correction factor of (33.573 - 33.506) / (33.506 - 21.900) + 1 = 1.0058 was thus established for the Li₂CO₃ powder.

An analogous technique was applied to a barrel of high-purity Nb₂O₅ powder in establishing a moisture loss correction factor of 1.0002.

A 948.8±.05 g mass of powder was then withdrawn from the barrel of Li₂CO₃. Considering the measured atomic weight for Li, the moisture loss correction factor of 1.0058, and the expected evolution of CO₂ gas on reaction, this 948.8±.05 g mass of powder was determined to amount to 381.48±.02 g of Li₂O to be contributed to an Li₂CO₃/Nb₂O₅ powder mix that was subsequently reacted to form a charge of lithium niobate.

A 3619.7±.05 g mass of powder was now withdrawn from the barrel of Nb₂O₅ Considering the moisture loss correction factor of 1.0002, this 3619.7±.05 g mass of powder was determined to amount to 3619.0±.05 g of Nb₂O₅ to be contributed to the aforementioned powder mix.

The Li₂CO₃ and Nb₂O₅ powder masses were combined in a powder blender and mixed for 30 minutes. The mixed powders were placed in a Pt crucible and reaction-melted in a furnace at roughly 1300°C. The molten charge was poured into a smaller Pt crucible and allowed to solidify. Through previous quantitative experimental analysis of the extent and chemical nature of volatilization losses associated with this process, it had been established that reaction-melting of the powder mix would result in a preferential loss of 0.15±.12 g of Li₂O. It should be noted that the uncertainity in this last value is predominantly systematic and not random. Thus, this uncertainity has an impact predominantly on the absolute accuracy, as opposed to the reproducibility, of compositional specification.

The resulting 381.33±.14 g mass of Li₂O and the 3619.0±.05 g mass of Nb₂O₅ are thus in a ratio such that (Li₂O/(Li₂O + Nb₂O₅)) x 100 = 48.380±.01. This value of 48.380 was the composition of the charge from which a crystal was drawn.

### Growing the Crystal

The smaller crucible containing the solidified charge was placed appropriately in a typical Czochralski crystal growth station. The station was heated, the charge was melted, and then a lithium niobate crystal measuring roughly 8 cm in diameter by 12 cm in length was grown.

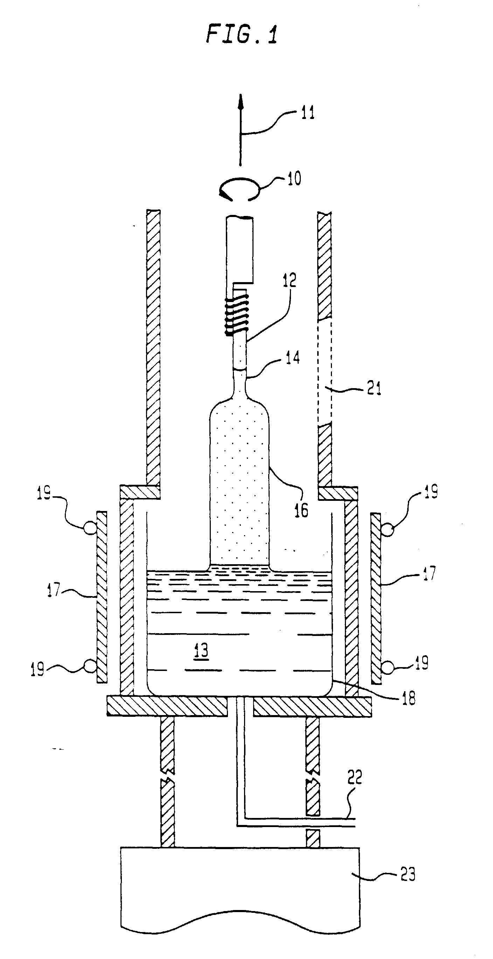

Fig. 1 is a schematic diagram of a typical conventional Czochralski station. Such a station appears in Chapter 4 in J.C. Brice's Crystal Growth Processes (Blackie & Son, Glasgow, 1986). Crystal rotation indicated by arrow 10 has a rate range between five and fifty revolutions per minute. Growth rates range between 0.3 and 0.7 cm/hour whose direction is indicated by arrow 11. The growing process starts with a crystal seed 12 tied into a V-groove. The seed 12 is placed in contact with melt 13 and drawn upward while rotating. First, a neck 14 is produced and then the boule 16 of useable crystal forms. The melt 13 is heated by radio frequency coil 17 (or resistance heating) in a platinum crucible 18. Water cooling 19 is also used to provide a controlled thermal load. The process may be monitored visually through viewing slot 21 as well as by thermocouple 22 and weight transducer 23. The growth process consumes about sixty-eight hours from initial heat-up to harvest of the grown crystal.

After the furnace was cooled and the crystal removed, samples were cut out from near each end of the crystal. The samples measured 1 X 1 cm square by 2 mm thick, with the thickness in the crystallographic Z direction.

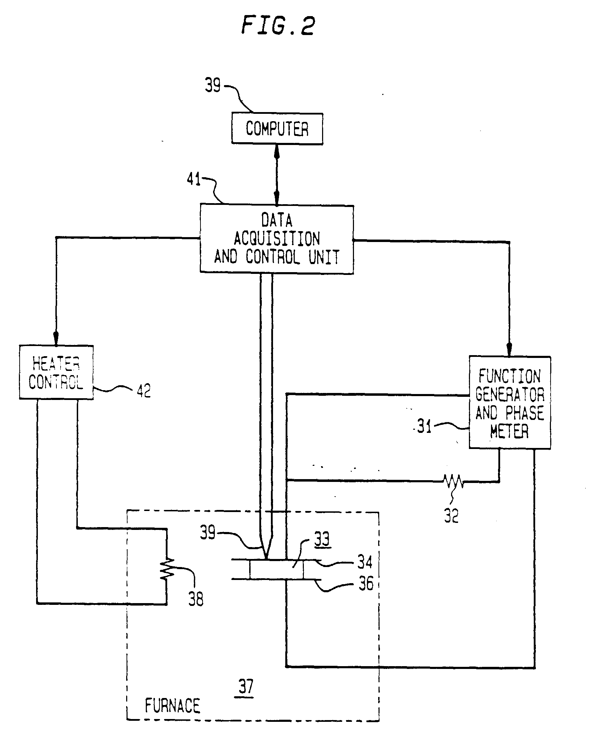

Using the Curie point measurement system illustrated in Fig. 2, these samples were each determined to have a ferroelectric Curie transition temperature of 1142.3 ± 0.3°C.

### Curie Point Measurement of Crystal Composition

The historical basis for the invention was the development of a highly accurate and efficient system for measuring lithium niobate crystal composition, originally undertaken for use in lithium niobate crystal production quality control. The system is based on identification of the dielectric effects of the ferroelectric Curie transition that occurs in lithium niobate at temperatures between roughly 1100 and 1250°C, the exact temperature dependent on the value of the Li:Nb ratio.

Fig. 2 is an overall schematic diagram of the measurement system. In essence, a phase meter 31 records the phase offset between two legs of an AC signal. One leg passes through a reference resistor 32, the other leg through the crystal sample 33 being measured. The sample is mounted between thin platinum plate contacts 34 and 36 in a small, controllable furnace 37 which has a resistance heater 38. Four calibrated thermocouples (symbolically represented by one thermocouple 39) are held in contact with the platinum plates 34 and 36 via a spring-loaded assembly (not shown). As the temperature of the furnace is cycled, the phase meter 31 records a sharp maximum in the AC phase offset between the two circuit legs as the sample 33 passes through its ferroelectric/ paraelectric Curie transition. Such maxima occur on both heating and cooling cycles. Phase offset maxima and corresponding thermocouple readings are recorded through use of a digital data acquisition unit. Operation of the entire measurement system is coordinated by a programmed desktop computer 39. Specifically, computer 39 analyses the data and directs control unit 41 to act by coordinating the operation of heater control 42 of furnace 37 and that of function generator and phase meter 31. Although the concepts underlying the measurement system are in themselves not novel, their particular employment in the system of Fig. 2 enables unprecedented precision and accuracy in measuring lithium niobate Curie temperatures. Through adjustment of the AC frequency, typically on the order of 1 MHz, the phase effect can be maximized to yield a sharp, reproducible peak. Owing to the intensity and sharpness of the phase offset peak, slow ramping of the furnace temperature measurements, on the order of 1°C/minute, is now feasible for Curie measurements. By contrast, in the case of DTA-based Curie temperature measurements such as performed in the earlier-cited work of O'Bryan et al., the relative weakness of the thermal signal associated with the ferroelectric-paraelectric Curie transition necessitates a temperature ramping rate in the range of at least 20°C/minute.

The lower temperature ramp rate possible in the present system enables higher resolution in the thermocouple-based temperature measurement, on the order of 0.1°C. Further, through use of four thermocouples positioned against either face of the sample and an adjustable sample holder, the system can be tuned for a given sample size to achieve sample placement in the thermal center of the furnace, thereby minimizing thermal gradient effects and maximizing absolute temperature measurement accuracy. Absolute accuracy of a Curie temperature measurement using the system is better than ± 0.3°C. Reproducibility of a given measurement is better than ± 0.1°C. These values of accuracy represent at least seven times greater precision than historically reported for such measurements on lithium niobate.

### Summary of Experiments Performed

In an initial phase of the effort to identify the lithium niobate congruent composition, the Curie point measurement system was used to analyze crystals grown from a variety of starting compositions, including compositions mentioned in above-noted publications. Sixteen crystals were grown and analyzed in this effort. These crystals have a cylindrical shape roughly of 8 cm in diameter by approximately 13 cm in length, each representing at least 85% of about a 4 kg liquid charge. The use of such large crystals was purposely made to minimize compositional ambiguities associated with finite measurement sample size. Large melt fractions were crystallized in order to maximize the effects of any incongruency. As implied by above discussion, extensive effort was devoted to proper treatment of issues such as moisture incorporation in starting chemicals, incongruent volatilization during liquid charge preparation and crystal growth, and variability in starting chemical isotopic ratios, that, if ignored, could lead to compositional inaccuracy.

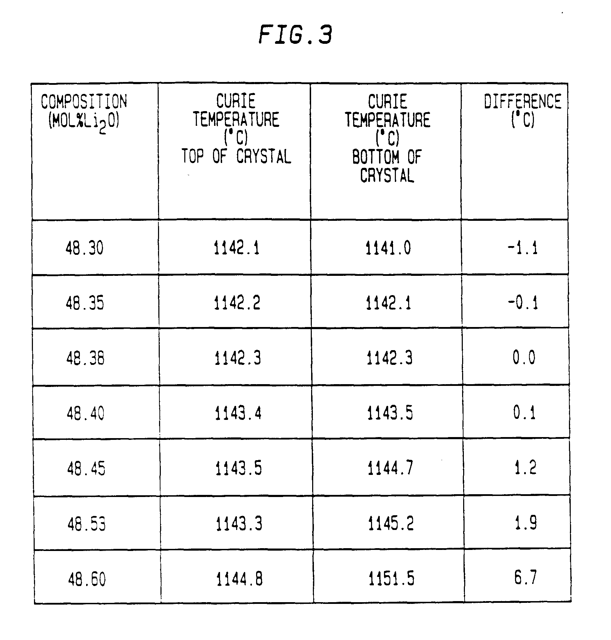

In Fig. 3, the table summarizes the results of this initial phase. The intervening material between the top and bottom Curie point samples from each crystal represented in each case a melt fraction of of roughly 0.70. The more uniform the Curie temperature from one end of a crystal to the other, the closer to congruency was the solidification process by which it was produced. Based on the data collected, the preferred composition for lithium niobate crystal growth appears to be roughly 48.38 mol% Li. Further, within the limits of Curie point measurement precision, and for a 0.70 melt fraction crystallized between top and bottom samples, both 48.35 and 48.40 mol% Li charge compositions appeared to yield compositionally uniform crystalline material.

The Curie point based results presented in Fig. 3 were corroborated through measurement of the phase-match temperatures for second harmonic generation of a 1.06 micron Nd:YAG laser beam. In a manner similar to the Curie point measurements, phase match temperature uniformity from one end of a crystal to the other indicates congruency of the solidification process.

A second phase of the effort to identify the lithium niobate congruent composition was directed toward the compositional region in the vicinity of 48.38 mol% Li. In this phase, crystals of tightly controlled compositions on either side of 48.380 mol% Li were grown to unprecedented melt fractions to amplify effects of incongruency to enable the Curie point measurement technique to more finely resolve the congruent composition.

Crystals were grown from melt compositions of 48.375±.010 mol% Li and 48.385±.010 mol% Li. The crystals represented sufficiently large melt fractions that intervening material between top and bottom Curie point samples represented melt fractions of at least 0.80.

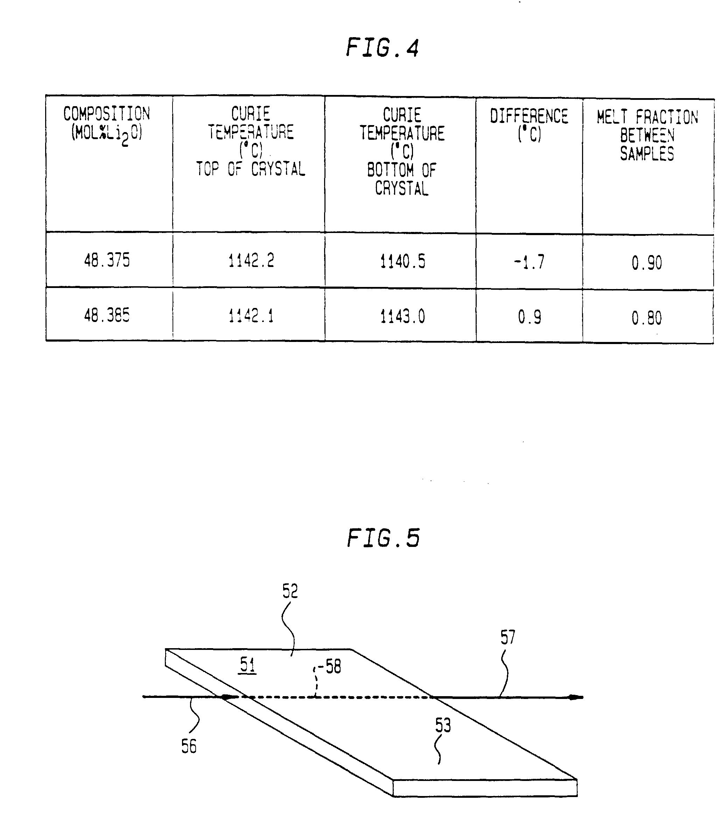

In Fig. 4, the table summarizes the results. The Curie point measurements indicate the 48.375 composition to be on the lithium poor side of congruency with the 48.385 composition on the lithium rich side. Considering that, as noted above, the majority of the ±.010 mol% Li uncertainity in specifying the composition of the 48.375 and 48.385 boules is systematic and not random, it may be conservatively concluded that the congruent composition for lithium niobate crystallization is 48.380±.015 mol% Li.

It should be noted that this value of 48.380 mol% Li for the lithium niobate congruent composition is neither indicated nor implied as being preferred by any prior art papers.

Further work was devoted to analysis of crystal production yield using the 48.38 mol% Li composition. Seventy crystals were grown over a period of roughly eight months in this effort. Crystals ranged from 8 to 13 cm in diameter and from 7 to 15 cm in length. All crystal orientations common in lithium niobate commercial crystal production were used. Solidified melt fractions were as high as 97%.

Ten of these crystals were analyzed using the Curie point measurement system. In all cases, within the limits of measurement precision, Curie point variation was undetectable, both within spatially displaced locations of any given crystal and from crystal to crystal in the series.

Moreover, based on twenty year's accumulation of data on lithium niobate crystal growth production yield, the 48.38 mol% Li charge composition enables unprecendented Czochralski growth production efficiency, in terms of both achievable growth rate and achievable crystallized melt fraction.

Fig. 5 illustrates a typical substrate 51 of homogeneous lithium niobate formed in accordance with the inventive principles. In order to form substrates, the lithium niobate boule is first sawed into slices. Then, the slices are polished to remove mechanical damage of the sawing operation and to obtain the desired thickness for the substrates. Finally, the slices may be divided into the individual substrates which may occur after the device processing procedure. Due to the homogeneity of the material, substrate 51 is better suited for acoustic or optical applications since all of its pertinent properties will have constant values.

In accordance with traditional acoustic applications, transducer (not shown) may be located at points 52 and 53. In this case, the transducers would be selected in accordance with providing a desired transfer function between the transducers. In accordance with an integrated optics application, a light beam 56 impinges on the side of the substrate 51 and propagates along path 58 before exiting as light beam 57. It is to be understood that along path 58 various electrodes and/or diffusion patterns may be made to achieve the desired function for substrate 51 as an integrated optic device.

There has thus been shown and described a novel process for forming homogeneous lithium niobate which fulfills all the objects and advantages sought therefor. In addition to the modifications already mentioned or alluded to in the foregoing, the starting composition may be used to advantage in other types of growth stations. Due to the constancy of the properties of the crystalline material, further applications of lithium niobate may result.

## Patentansprüche

1. Verfahren zur Herstellung von Lithiumniobatkristallen, bei dem man:
a) eine Charge Lithiumniobat mit einer Zusammensetzung von über 48,35 bis 48,395 Mol-% Li₂O, Rest Nb₂O₅, herstellt,
b) die Charge durch Erhitzen in den schmelzflüssigen Zustand überführt und
c) aus der schmelzflüssigen Charge einen verfestigten homogenen Kristall zieht, der im wesentlichen die gleiche Zusammensetzung wie die schmelzflüssige Charge aufweist.

2. Verfahren nach Anspruch 1, bei dem man in Schritt a) ferner die Charge so bemißt, daß sie 48,375 bis 48,385 Mol-% LiO₂ enthält.

3. Verfahren zur Herstellung von einkristallinem Lithiumniobat mit der folgenden Kombination von Schritten: Herstellung einer verfestigten Charge mit vermindertem Feuchtigkeitsgehalt und 48,365 bis 48,395 Mol-% Li₂O, Rest Nb₂O₅; Erhitzen der verfestigten Charge und Überführung in den schmelzflüssigen Zustand und Ziehen eines homogenen Kristalls aus der schmelzflüssigen Charge, wobei man einen festen Kristall erhält, der im wesentlichen den gleichen Molprozentanteil an Li₂O wie die schmelzflüssige Charge aufweist.

4. Verfahren nach Anspruch 3, bei dem man im Ziehschritt einen Keimkristall wählt, dessen Wachstumsoberfläche eine Kristallwachstums-Orientierungsrichtung bestimmt, und den Kristall so lange wachsen läßt, bis der als Feststoff gebildete homogene Kristall mindestens einem Anteil von 0,90 der schmelzflüssigen Charge entspricht.

5. Verfahren nach Anspruch 3, bei dem man im Herstellungsschritt eine verfestigte Charge, die einer Menge an schmelzflüssiger Charge von etwa vier Kilogramm entspricht, mischt.

6. Verfahren nach Anspruch 5, bei dem man den festen Kristall zu einem Block mit generell zylindrischer Form mit einem Nenndurchmesser von etwa 8 Zentimetern und einer Länge von 13 Zentimetern formt.

7. Verfahren zum Ausfrieren von Lithiumniobat aus einer schmelzflüssigen Lösung, bei dem man: eine schmelzflüssige Lösung aus zwei Komponenten, wobei es sich bei der ersten Komponente um Lithiumoxid und bei der zweiten Komponente um Niobpentoxid handelt, der Anteil der ersten Komponente im Bereich von 48,365 bis 48,395 Mol-% liegt und die zweite Komponente den restlichen Teil der schmelzflüssigen Lösung bildet, bereitstellt und daraus einen Block aus homogenem einkristallinem Lithiumniobat zieht, wobei der Lithiumniobatblock die gleiche Zusammensetzung wie die schmelzflüssige Lösung aufweist.

8. Verfahren nach Anspruch 7, bei dem man im Ziehschritt den Lithiumniobatblock dadurch bildet, daß man im wesentlichen die gesamte schmelzflüssige Lösung verfestigt.

9. Durch Schneiden des verfestigten homogenen Kristalls nach Anspruch 1 hergestelltes Lithiumniobat-Substratmaterial für akustische Oberflächenwellen, wobei das Substratmaterial überall in jedem Substrat und von Substrat zu Substrat einheitliche Eigenschaften aufweist.

10. Durch Schneiden des festen Kristalls nach Anspruch 3 hergestelltes Lithiumniobat-Substratmaterial für die integrierte Optik, enthaltend eine homogene Zusammensetzung von einkristallinem Lithiumniobat mit einheitlichen Eigenschaften einschließlich konstanter Doppelbrechung.

11. Durch Schneiden des festen Kristalls nach Anspruch 3 hergestelltes Lithiumniobat-Substratmaterial für akustische Oberflächenwellen, wobei das Substratmaterial überall in jedem Substrat und von Substrat zu Substrat einheitliche Eigenschaften aufweist.

12. Durch Schneiden des verfestigten homogenen Kristalls nach Anspruch 1 hergestelltes Lithiumniobat-Substratmaterial für die integrierte Optik, enthaltend eine homogene Zusammensetzung von Lithiumniobat und bevorzugt einkristallinem Lithiumniobat mit einheitlichen Eigenschaften einschließlich konstanter Doppelbrechung.

13. Verfahren nach Anspruch 1, bei dem man in Schritt c) den verfestigten homogenen Kristall so zieht, daß man einen Verfestigungsanteil des homogenen Kristalls erhält, der einem Anteil von mindestens 0,85 der schmelzflüssigen Charge entspricht.

14. Verfahren zur Herstellung eines Lithiumniobatkristalls, bei dem man:
eine schmelzflüssige Charge mit einer Zusammensetzung von über 48,35 bis 48,40 Mol-% Li₂O, Rest Nb₂O₅, herstellt und
die schmelzflüssige Charge in weitgehend kongruenter Weise verfestigt, indem man aus der schmelzflüssigen Charge einen weitgehend homogenen Lithiumniobatkristall zieht, der im wesentlichen die gleiche Zusammensetzung wie die schmelzflüssige Charge aufweist.

15. Verfahren nach Anspruch 14, bei dem man eine schmelzflüssige Charge mit etwa 48,375 bis 48,385 Mol-% Li₂O, Rest Nb₂O₅, einsetzt.

16. Verfahren nach Anspruch 14, bei dem man eine schmelzflüssige Charge mit etwa 48,365 bis 48,395 Mol-% Li₂O, Rest Nb₂O₅, einsetzt.

17. Verfahren nach Anspruch 14, bei dem man mindestens einen Anteil von 0,85 der schmelzflüssigen Charge zu einem weitgehend homogenen Kristall verfestigt.

18. Verfahren nach Anspruch 14, bei dem man mindestens einen Anteil von 0,90 der schmelzflüssigen Charge zu einem weitgehend homogenen Kristall verfestigt.

19. Verfahren nach Anspruch 14, bei dem man eine schmelzflüssige Charge mit einem Gewicht von etwa vier Kilogramm einsetzt.

20. Verfahren nach Anspruch 14, bei dem man einen weitgehend homogenen Kristall mit allgemein zylindrischer Form mit einem Durchmesser von etwa 8 Zentimetern und einer Länge von etwa 13 Zentimetern herstellt.

21. Verfahren nach Anspruch 14, bei dem man im wesentlichen die gesamte Charge zu einem weitgehend homogenen Kristall verfestigt.

22. Verfahren nach Anspruch 14, bei dem man ferner den homogenen Kristall in mehrere Scheiben zerteilt, wobei jede Scheibe ein Substrat darstellt.

23. Homogenes Lithiumniobat-Substrat für akustische Oberflächenwellen, hergestellt nach dem Verfahren gemäß Anspruch 22.

24. Homogenes Lithiumniobat-Substrat für die integrierte Optik, hergestellt nach dem Verfahren gemäß Anspruch 22.

25. Homogener Lithiumniobatkristall, hergestellt nach dem Verfahren gemäß Anspruch 14.

26. Weitgehend homogene Lithiumniobatkristallzusammensetzung, enthaltend:
über 48,35 bis 48,40 Mol-% Li₂O.

27. Weitgehend homogene Lithiumniobatkristallzusammensetzung, enthaltend:
48,38 +/- 0,015 Mol-% Li₂O.

## Claims

1. A process for making lithium niobate crystal, the process comprising the steps of
a) preparing a charge of lithium niobate having a mol percentage composition of Li₂O from but not including 48.35 to 48.395 and the remainder Nb₂O₅,
b) heating the charge to a temperature to provide a molten charge, and
c) drawing a solidified homogeneous crystal from the molten charge having a composition essentially the same as that of the molten charge.

2. The process of claim 1, wherein the step of a) further comprises controlling the charge to have a mol percentage composition of 48.375 to 48.385, for the Li₂O.

3. In a process for producing monocrystalline lithium niobate, a combination of steps comprising: preparing a solidified charge of reduced moisture content comprising a mol percentage content of 48.365 to 48.395 of Li₂O and the remainder Nb₂O₅; heating and converting the solidified charge into a molten charge; and drawing a homogeneous crystal from the molten charge to produce a solid crystal whose composition of mol percentage Li₂O is essentially the same as the mol percentage of Li₂O in the molten charge.

4. In the process of claim 3, wherein the step of drawing comprises the steps of: selecting a crystal seed whose growth surface determines a direction for an orientation of crystal growth, and maintaining the crystal growth until the homogeneous crystal formed as a solid corresponds to at least 0.90 of the molten charge.

5. In the process of claim 3, wherein the steps of preparing includes: mixing a solidified charge corresponding to approximately a four kilogram molten charge.

6. In the process of claim 5, wherein the solid crystal is formed into a boule having a generally cylindrical shape having a nominal diameter of approximately 8 centimeters and a length of 13 centimeters.

7. A process for freezing lithium niobate out of a melt solution, the process comprising the steps of:
providing a melt solution having a composition of two components, the first component being lithium oxide and the second component being niobium pentoxide, the mol percentage of the first component being in the range of 48.365 to 48.395 with the second component occupying the remaining portion of the melt solution, and
drawing a homogeneous monocrystalline lithium niobate boule out of the melt soluticn wherein the relationship of the composition of the lithium niobate boule is the same as the melt solution composition.

8. The process of claim 7, wherein the step of drawing includes forming the lithium niobate boule by solidifying essentially all of the melt solution.

9. Lithium niobate acoustic surface wave substrate material made from slicing the solidified homogeneous crystal of claim 1, the substrate material having uniform properties throughout each substrate and from one substrate to another substrate.

10. Lithium niobate integrated optic substrate material made form slicing the solid crystal of claim 3, the substrate material comprising: a homogeneous composition of monocrystalline lithium niobate having uniform properties including a constant birefringence.

11. Lithium niobate acoustic surface wave substrate material made from slicing the solid crystal of claim 3, the substrate material having uniform properties throughout each substrate and from one substrate to another substrate.

12. Lithium niobate integrated optic substrate material made from slicing the solidified homogeneous crystal of claim 1, the substrate material comprising: a homogeneous compositoin of lithium niobate and prefered monochrystalline Lithium niobate having uniform properties including a constant birefringence.

13. The process of claim 1 wherein the step of c) comprises pulling the solidified homogeneous crystal to obtain a solidification fraction for the homogeneous crystal corresponding to at least 0.85 of the molten charge.

14. A process for making a lithium niobate crystal, comprising the steps of:
preparing a molten charge having an Li₂O mole percentage composition from but not including 48.35 to 48.40, the remainder of the molten charge being Nb₂O₅; and
solidifying the molten charge in substantially congruent fashion by drawing a substantially homogeneous lithium niobate crystal from the molten charge, the crystal having substantially the same composition as that of the molten charge.

15. The process of claim 14, in which the mole percentage of Li₂O in the molten charge is about 48.375 to 48.385, the remainder of the molten charge being Nb₂O₅.

16. The process of claim 14, in which the mole percentage of Li₂O in the molten charge is about 48.365 to 48.395, the remainder of the molten charge being Nb₂O₅.

17. The process of claim 14, in which at least 0.85 of the molten charge is solidified into a substantially homogeneous crystal.

18. The process of claim 14, in which at least 0.90 of the molten charge is solidified into a substantially homogeneous crystal.

19. The process of claim 14, in which the molten charge is an approximately four kilogram charge.

20. The process of claim 14, in which the substantially homogeneous crystal has a generally cylindrical shape approximately 8 cm. in diameter and approximately 13 cm. long.

21. The process of claim 14, in which essentially all of the molten charge is solidified into a substantially homogeneous crystal.

22. The process of claim 14, further comprising the step of dividing the homogeneous crystal into a plurality of slices, each slice comprising a substrate.

23. A homogeneous lithium niobate acoustic surface wave substrate prepared in accordance with the process of claim 22.

24. A homogeneous lithium niobate integrated optic substrate prepared in accordance with the process of claim 22.

25. A homogeneous lithium niobate crystal prepared in accordance with the process of claim 14.

26. A substantially homogeneous lithium niobate crystal composition comprising:
an Li₂O mole percentage composition from but not including 48.35 to 48.40 .

27. A subsstantially homogeneous lithium niobate crystal composition comprising:
an Li₂O mole percentage compositoin of 48.38 +/- 0.015.

## Revendications

1. Procédé de préparation de cristal de niobate de lithium, le procédé comprenant les étapes de :
a) préparation d'une charge de niobate de lithium ayant une composition en pourcentage molaire de Li₂O allant, mais n'incluant pas, de 48,35 à 48,395, le reste étant du Nb₂O₅,
b) chauffage de la charge à une certaine température pour obtenir une charge fondue, et
c) tirage d'un cristal homogène solidifié à partir de la charge fondue ayant une composition sensiblement identique à celle de la charge fondue.

2. Procédé selon la revendication 1, dans lequel l'étape a) comprend en outre le réglage de la charge pour qu'elle ait une composition en pourcentage molaire de 48,375 à 48,385, pour le Li₂O.

3. Dans un procédé de production de niobate de lithium monocristallin, une combinaison d'étapes comprenant : la préparation d'une charge solidifiée ayant une teneur réduite en eau comprenant une teneur en pourcentage molaire de 48,365 à 48,395 de Li₂O, le reste étant du Nb₂O₅; le chauffage et la transformation de la charge solidifiée en charge fondue; et le tirage d'un cristal homogène à partir de la charge fondue pour produire un cristal solide dont la composition en pourcentage molaire de Li₂O est essentiellement identique au pourcentage molaire de Li₂O dans la charge fondue.

4. Dans le procédé de la revendication 3, dans lequel l'étape de tirage comporte les étapes de : choix d'un germe de cristal dont la surface de croissance détermine une direction pour une orientation de croissance cristalline, et maintien de la croissance cristalline jusqu'à ce que le cristal homogène formé sous forme de solide corresponde à au moins 0,90 de la charge fondue.

5. Dans le procédé de la revendication 3, dans lequel les étapes de préparation comprennent : le mélange d'une charge solidifiée correspondant approximativement à une charge fondue de quatre kilogrammes.

6. Dans le procédé de la revendication 5, dans lequel le cristal solide est formé en une boule ayant une forme globalement cylindrique d'un diamètre nominal d'environ 8 centimètres et d'une longueur de 13 centimètres.

7. Procédé de congélation de niobate de lithium à partir d'une solution à l'état fondu, le procédé comprenant les étapes de : fourniture d'une solution à l'état fondu ayant une composition à deux constituants, le premier constituant étant l'oxyde de lithium et le second constituant étant le pentoxyde de niobium, le pourcentage molaire du premier constituant étant compris entre 48,365 et 48,395, le second constituant occupant le partie restante de la solution à l'état fondu, et tirage d'une boule de niobate de lithium monocristallin homogène à partir de la solution à l'état fondu, où la relation de la composition de la boule de niobate de lithium est identique à celle de la composition de la solution à l'état fondu.

8. Procédé selon la revendication 7, dans lequel l'étape de tirage comprend la formation de la boule de niobate de lithium par solidification de la quasi-totalité de la solution à l'état fondu.

9. Matériau de substrat d'ondes acoustiques de surface en niobate de lithium fabriqué par découpe en tranches du cristal homogène solidifié selon la revendication 1, le matériau de substrat ayant des propriétés uniformes d'un bout à l'autre de chaque substrat et d'un substrat à un autre substrat.

10. Matériau de substrat optique intégré en niobate de lithium fabriqué par découpe en tranches du cristal solide selon la revendication 3, le matériau de substrat comprenant : une composition homogène de niobate de lithium monocristallin ayant des propriétés uniformes, parmi lesquelles une biréfringence constante.

11. Matériau de substrat d'ondes acoustiques de surface en niobate de lithium fabriqué par découpe en tranches du cristal solide selon la revendication 3, le matériau de substrat ayant des propriétés uniformes d'un bout à l'autre de chaque substrat et d'un substrat à un autre substrat.

12. Matériau de substrat optique intégré en niobate de lithium fabriqué par découpe en tranches du cristal homogène solidifié selon la revendication 1, le matériau de substrat comprenant : une composition homogène de niobate de lithium et le niobate de lithium monocristallin préféré ayant des propriétés uniformes, parmi lesquelles une biréfringence constante.

13. Procédé selon la revendication 1 dans lequel l'étape c) comprend le tirage du cristal homogène solidifié pour obtenir une fraction de solidification pour le cristal homogène correspondant à au moins 0,85 de la charge fondue.

14. Procédé de préparation d'un cristal de niobate de lithium, comportant les étapes de :
préparation d'une charge fondue ayant une composition en pourcentage molaire de Li₂O allant, mais n'incluant pas, de 48,35 à 48,40, le reste de la charge fondue étant du Nb₂O₅; et
solidification de la charge fondue d'une manière substantiellement congruente en tirant un cristal de niobate de lithium sensiblement homogène à partir de la charge fondue, le cristal ayant sensiblement la même composition que celle de la charge fondue.

15. Procédé selon la revendication 14, dans lequel le pourcentage molaire de Li₂O dans la charge fondue est d'environ 48,375 à 48,385, le reste de la charge fondue étant du Nb₂O₅.

16. Procédé selon la revendication 14, dans lequel le pourcentage molaire de Li₂O dans la charge fondue est d'environ 48,365 à 48,395, le reste de la charge fondue étant du Nb₂O₅.

17. Procédé selon la revendication 14, dans lequel au moins 0,85 de la charge fondue est solidifiée en un cristal sensiblement homogène.

18. Procédé selon la revendication 14, dans lequel au moins 0,90 de la charge fondue est solidifiée en un cristal sensiblement homogène.

19. Procédé selon la revendication 14, dans lequel la charge fondue est une charge d'environ quatre kilogrammes.

20. Procédé selon la revendication 14, dans lequel le cristal sensiblement homogène a une forme globalement cylindrique d'environ 8 cm de diamètre et d'environ 13 cm de long.

21. Procédé selon la revendication 14, dans lequel la quasi-totalité de la charge fondue est solidifiée en un cristal sensiblement homogène.

22. Procédé selon la revendication 14, comportant en outre l'étape de division du cristal homogène en une pluralité de tranches, chaque tranche comprenant un substrat.

23. Substrat d'ondes acoustiques de surface en niobate de lithium homogène préparé conformément au procédé selon la revendication 22.

24. Substrat optique intégré en niobate de lithium homogène préparé conformément au procédé selon la revendication 22.

25. Cristal de niobate de lithium homogène préparé conformément au procédé selon la revendication 14.

26. Composition de cristal de niobate de lithium sensiblement homogène comprenant :
une composition en pourcentage molaire de Li₂O allant, mais n'incluant pas, de 48,35 à 48,40.

27. Composition de cristal de niobate de lithium sensiblement homogène comprenant :
une composition en pourcentage molaire de Li₂O de 48,38 ± 0,015.
